(19) Europäisches Patentamt
European Patent Office
Office européen des brevets

(11) **EP 2 028 463 B1**

(12) **EUROPÄISCHE PATENTSCHRIFT**

(45) Veröffentlichungstag und Bekanntmachung des Hinweises auf die Patenterteilung:
**21.10.2009 Patentblatt 2009/43**

(51) Int Cl.:
*G01J 3/26* *(2006.01)*        *G01J 5/34* *(2006.01)*
*G01N 21/35* *(2006.01)*        *H01L 37/02* *(2006.01)*

(21) Anmeldenummer: **07015884.5**

(22) Anmeldetag: **13.08.2007**

(54) **Anordnung und Verfahren zur Wellenlängen-Referenzierung von durchstimmbaren Fabry-Perot-Interferometern**

Assembly and method for wavelength referencing of variable frequency Fabry-Perot interferometers

Dispositif et procédé destinés au référencement par longueurs d'onde d'interféromètres Fabry-Pérot déterminables

(84) Benannte Vertragsstaaten:
**AT BE BG CH CY CZ DE DK EE ES FI FR GB GR HU IE IS IT LI LT LU LV MC MT NL PL PT RO SE SI SK TR**

(43) Veröffentlichungstag der Anmeldung:
**25.02.2009 Patentblatt 2009/09**

(73) Patentinhaber: **InfraTec GmbH**
**01217 Dresden (DE)**

(72) Erfinder:
• **Neumann, Norbert**
  **01744 Dippoldiswalde (DE)**

• **Ebermann, Martin**
  **01796 Pirna (DE)**

(74) Vertreter: **Pfenning, Meinig & Partner GbR**
**Patent- und Rechtsanwälte**
**An der Frauenkirche 20**
**01067 Dresden (DE)**

(56) Entgegenhaltungen:
**DE-C1- 10 035 423        US-A- 5 646 729**
**US-A1- 2003 116 711**

EP 2 028 463 B1

**Beschreibung**

Die Erfindung betrifft eine Anordnung und Verfahren zur Wellenlängen-Referenzierung von durchstimmbaren Fabry-Perot-Interferometern. Es können dabei Stoffe, die in einem Fluid enthalten sind bzw. darin enthalten sein können bestimmt werden. Mit ihr kann auch die jeweilige Konzentration mindestens eines im Fluid (Gas, Flüssigkeit, Atmosphäre) enthaltenen Stoffs bestimmt werden. Sie betrifft auch ein Verfahren zur Wellenlängen-Referenzierung einer solchen Anordnung.

Zur Bestimmung von Stoffen und/oder Stoffkonzentrationen, die in unterschiedlichsten Fluiden und insbesondere Gasen, die ein Gemisch einer Vielzahl von Stoffen enthalten können, werden häufig Messsysteme, die mit einem durchstimmbaren Fabry-Perot-Interferometer ausgebildet sind, eingesetzt.

Sie können dabei für die Bestimmung von in Gemischen mit anderen Stoffen enthaltenen Gasen, wie z.B. Methan, Kohlendioxid, Kohlenmonoxid aber auch höher molekularer chemischer Verbindungen eingesetzt werden.

Solche Messsysteme sind aus der US 5646729 bzw. US 2003/116711 bekannt.

Bei durchstimmbaren Fabry-Perot-Interferometern sind zwei Reflektoren (Bragg-Reflektoren aus Stapeln hoch- und niedrigbrechender dielektrischer Schichtpaare) vorhanden, die in geringem Abstand planparallel zueinander angeordnet sind. Die Reflektoren bilden mit dem Zwischenraum einen optischen Resonator. Es wird nur Strahlung transmittiert, deren Wellenlänge $\lambda_m$ die (stark vereinfachte) Interferenzbedingung $\lambda_m = 2*n*d/m$ erfüllt, wobei n die Brechzahl des Mediums im Resonanzraum und m eine Ordnungszahl ist. Durch Variation des Abstandes der Reflektoren wird die Transmissionswellenlänge des Resonators verändert, so dass man eine Abstimmung über einen Wellenlängenbereich erreicht. Elektrostatische Antriebskräfte werden zur definierten Einstellung der Wellenlänge genutzt. Die jeweilige elektrische Spannung, die an entsprechende Antriebselektroden angelegt ist, bestimmt den Abstand zwischen den Reflektoren und demzufolge auch die jeweilige Durchlasswellenlänge, so dass eine Abstimmung auf jeweils gewünschte Absorptionsbanden für einen oder mehrere Stoff(e) möglich ist.

Es hat sich aber gezeigt, dass durch verschiedenste Einflüsse, wie z.B. eine Veränderung des Federverhaltens (Federkonstante) einer Aufhängung für mindestens einen Reflektor eines Fabry-Perot-Interferometers, jeweils verändert wirkende Gravitations- oder andere Beschleunigungskräfte, sich verändernde Temperaturen und ggf. auch die Dichte bzw. Zusammensetzung der Atmosphäre bei bzw. in der ein Einsatz erfolgt, zu Fehlern führt so dass bei einer vorab bestimmten elektrischen Spannung, die an die Antriebselektroden angelegt ist, ein von der Vorgabe abweichender Abstand auftritt, was wiederum zu einer Änderung der Durchlasswellenlänge führt.

So wurden aufwändige Kalibriermessungen erforderlich, die mit zusätzlichen externen technischen Mitteln durchgeführt werden mussten.

Um dies zu vermeiden hat man gemäß der DE 696 28 974 T2 entnehmbaren technischen Lehre eine interne Referenzierung vorgeschlagen. Dabei wird ein optisches Element, das mindestens eine bestimmte charakteristische Wellenlänge aufweist und das an solchen Messanordnungen häufig ohnehin vorhanden ist, genutzt. Dies kann bevorzugt ein Bandpassfilter sein, dessen mindestens eine Kante als charakteristische Wellenlänge nutzbar ist.

Bei der Referenzierung wird das Fabry-Perot-Interferometer so durchgestimmt, dass ein Wellenlängenintervall durchfahren wird, das auch die charakteristische Wellenlänge des jeweiligen optischen Elements umfasst. Der dabei erfasste elektrische Spannungswert wird mit der Vorgabe für diese Wellenlänge verglichen und für den Fall einer aufgetretenen Abweichung von der Vorgabe kann korrigierend eingegriffen werden. Dieser Vorgang kann regelmäßig in mehr oder weniger großen Zeitabständen durchgeführt werden.

Dabei ist es aber nachteilig, dass bei einer so durchgeführten Referenzierung keine eigentliche Detektion durchführbar ist und so zwangsläufig Messpausen in Kauf genommen werden müssen. Die Kalibrierläufe sollen dabei auch noch mehrfach wiederholt werden, was sich selbstverständlich zusätzlich kontraproduktiv auswirkt. Weiterhin erfolgt die Referenzierung nur an einer Wellenlänge, die innerhalb des Durchstimmbereiches des Fabry-Perot-Interferometers liegen muß. Dadurch wird die Kalibrierung ungenau. Häufig kann dieser Teil des Durchstimmbereiches, der für die Wellenlängen-Kalibrierung an einer Bandpasskante gebraucht wird, nicht für die Bestimmung von Stoffen genutzt werden.

Es ist daher Aufgabe der Erfindung Möglichkeiten vorzuschlagen, mit denen eine interne Wellenlängen-Referenzierung von Fabry-Perot-Interferometern in kurzer Zeit und in einfacher Form simultan zur eigentlichen Messung der Stoffkonzentration durchgeführt werden kann.

Erfindungsgemäß wird diese Aufgabe mit einer Anordnung, die die Merkmale des Anspruchs 1 aufweist, gelöst. Dabei kann mit einem Verfahren gemäß Anspruch 12 verfahren werden.

Vorteilhafte Ausgestaltungen und Weiterbildungen der Erfindung können mit in untergeordneten Ansprüchen bezeichneten Merkmalen erreicht werden.

Eine erfindungsgemäße Anordnung ist dabei in wesentlichen Punkten so aufgebaut, wie dies aus dem Stand der Technik bekannt ist. So wird elektromagnetische Strahlung einer Quelle durch ein Fluid, in dem ein zu detektierender Stoff enthalten ist oder darin enthalten sein kann, auf die Anordnung gerichtet.

Eine bestimmte Wellenlänge, die einer Absorptionsbande dieses Stoffs entspricht, kann durch Steuerung des Abstandes der reflektierenden plattenförmigen Elemente eines Fabry-Perot-Interferometers mit einer bestimmten elektrischen Spannung ausgewählt werden. Das Fabry-Perot-Interferometer ist dann für diese Wellenlänge der elektromagnetischen Strahlung transparent. Die elektromagnetische Strahlung mit dieser Wellenlänge trifft auf ein im Strahlengang hinter dem Fabry-Perot-Interferometer angeordnetes elektromagnetische Strahlung detektierendes Element auf, welches üblicherweise ein spektral breitbandiges und gleichmäßig detektierendes Element sein sollte.

Mit dem detektierenden Element, das als pyroelektrisches Element ausgebildet sein kann, kann in Abhängigkeit der Intensität der auftreffenden elektromagnetischen Strahlung ein elektrisches Messsignal generiert werden, das einer elektronischen Auswerte- und Steuereinheit zugeführt werden kann. Dabei kann ein pyroelektrisches Material eingesetzt werden, das bevorzugt im Durchstimmbereich des Fabry-Perot-Interferometers einen geringen Absorptionskoeffizienten k kleiner 0,01 aufweist.

An geeigneten elektromagnetische Strahlung detektierenden Elementen, insbesondere thermisch detektierenden Elementen, ist eine absorbierende Schicht vorhanden, welche die elektromagnetische Strahlung absorbiert und in eine Temperaturänderung des detektierenden Elements umwandelt, die mittels eines physikalischen Effektes in ein elektrisches Messsignal umgewandelt wird. Physikalische Effekte, welche die thermoelektrische Wandlung vornehmen, können z.B. der pyroelektrische Effekt oder die Temperaturabhängigkeit eines elektrischen Widerstandes sein. Im ersten Fall ist das detektierende Element als Plattenkondensator mit einem pyroelektrischen Material als Kondensatormedium aufgebaut und man spricht von einem pyroelektrischen Detektor. Im zweiten Fall ist das detektierende Element als elektrischer Widerstand aus einem Widerstandsmaterial mit hohem Temperaturkoeffizienten ausgebildet und wird als Bolometer bezeichnet.

Dabei trifft die vom Fabry-Perot-Interferometer durchgelassene elektromagnetische Strahlung üblicherweise direkt auf die absorbierende Schicht auf, die beim pyroelektrischen Detektor, die der Strahlung zugewandte Elektrode des Plattenkondensators ganz oder teilweise bedeckt. Bei der Erfindung wird aber auf die absorbierende Schicht verzichtet und das detektierende pyroelektrische Element gleichzeitig als optischer Resonator ausgebildet. Dies bedeutet, dass die sensitive pyroelektrische Schicht neben der thermoelektrischen Wandlung gleichzeitig als optisches Resonanzmedium und die Elektroden des Plattenkondensators als optische Reflektoren genutzt werden. Dadurch kann die elektromagnetische Strahlung zwischen den beiden Elektroden/Reflektorschichten durch die sensitive pyroelektrische Schicht hindurch mehrfach hin und her reflektiert werden, was Interferenzen hervorruft. Die Interferenzen haben einen großen Einfluss auf das Absorptionsverhalten des detektierenden pyroelektrischen Elements und bewirken eine wellenförmige Modulation der spektralen Empfindlichkeit durch die Ausbildung aufeinander folgender Minima und Maxima.

Die sensitive pyroelektrische Schicht eines erfindungsgemäß ausgebildeten elektromagnetische Strahlung detektierenden Elements kann aus einem für solche Elemente üblicherweise eingesetzten Stoff gebildet sein, wie dies bevorzugt Lithium-Tantalat oder auch andere oxidische Pyroelektrika, wie Niobate, Titanate und Zirkonate sind. Vorteilhaft sollte die Eigenabsorption des eingesetzten Stoffes im für die Bestimmung eines Stoffes genutzten Wellenlängenbereich sehr niedrig sein, damit Interferenzen ausgebildet werden können.

Die optische Schichtdicke n*d, die über die gesamte Fläche konstant sein sollte, ist dabei in Bezug zu den Schichtdicken für die weiteren Elektroden/Reflektor-Schichten, deutlich größer und sollte zwischen 20 und 90 $\mu$m, bevorzugt bei 40 $\mu$m liegen, wenn im Spektralbereich 3-5$\mu$m gemessen wird.

Die im Strahlengang der elektromagnetischen Strahlung vor und nach der sensitiven Schicht angeordneten Elektroden/Reflektor-Schichten sind deutlich dünner und sollten, insbesondere wegen ihrer gewünschten optischen Eigenschaften, eine Schichtdicke im Bereich 2 bis 20 nm, bevorzugt 6 nm aufweisen. Sie können aus geeigneten Metallen oder Legierungen ausgebildet werden. Bevorzugt kann dies eine Nickel-Chrom-Legierung, aber auch Chrom sein.

Die im Strahlengang vor der sensitiven pyroelektrischen Schicht ausgebildete Elektroden/Reflektor-Schicht und die dahinter ausgebildete Elektroden/Reflektor-Schicht können dann elektrisch leitend mit einer elektronischen Auswerte- und Steuereinheit verbunden sein, um die erfassten Messsignale an diese übertragen zu können.

Die beiden Elektroden/Reflektor-Schichten können aus optischen Gründen als Schichtfolge aus mehreren Einzelschichten aufgebaut sein, um das spektrale Absorptionsverhalten des detektierenden Elements möglichst deutlich auszubilden, d.h. mit ausreichend großer Amplitude zwischen Minima und Maxima.

Die im Strahlengang vor und hinter der sensitiven Schicht angeordneten Elektroden/Reflektor-Schichten sollten eine jeweils gleiche Schichtdicke aufweisen und aus dem gleichen Stoff(en) gebildet sein. Alle Schichtdicken und Schichten eines elektromagnetische Strahlung detektierenden Elements sollten über die gesamte Fläche homogen ausgebildet sein.

Wie bereits angesprochen, kommt es in Folge der Reflexionen zwischen den Elektroden/Reflektor-Schichten, die beidseitig der pyroelektrischen Schicht ausgebildet sind, zu Interferenzen mit mehrfacher Ordnung. Dabei hängt die Anzahl k der zwischen den Wellenlängen $\lambda 1$ und $\lambda 2$ erfassbaren Minima/Maxima nur von der optischen Dicke der sensitiven pyro elektrischen Schicht ab:

$$k = 2*n*d*(1/\lambda 1 - 1/\lambda 2).$$

Dadurch sind auch der Abstand zwischen den Minima/Maxima und die Wellenlänge der Minima/Maxima definiert. Die optische Dicke der sensitiven pyroelektrischen Schicht ist nur minimal von der Temperatur abhängig und liegt z.B. bei Lithium-Tantalat in der Größenordnung von 0,1 nm/K.

Gelangt die durch das Fabry-Perot-Interferometer gefilterte elektromagnetische Strahlung auf das erfindungsgemäße Element, entsteht ebenfalls ein wellenförmiger Verlauf des Messsignals, wenn das Fabry-Perot-Interferometer durchgestimmt wird.

Die optische Dicke n*d und damit der Abstand der Minima und Maxima sollte dabei vorteilhaft so gewählt werden, dass diese, bei einer gegebenen Bandbreite der durch das Fabry-Perot-Interferometer transmittierten Strahlung, mit ausreichendem Kontrast durch das Messsignal abgebildet werden können. Diese Signatur kann bei einer Wellenlängen-Referenzierung mittels eines hochauflösenden und genauen Spektrometers bestimmt und auf die Steuerspannung des Fabry-Perot-Interferometers bezogen werden. Wird bei einer Messung eine Abweichung zwischen Steuerspannung und der Lage der Minima/Maxima festgestellt, ist dies ein Indiz für einen Fehler bei der Einstellung des Abstands der reflektierenden Elemente des Fabry-Perot-Interferometers, was mit der elektronischen Auswerte- und Steuereinheit erkannt und bei der nachfolgenden Ansteuerung des Fabry-Perot-Interferometers durch gezielte Änderung der an das durchstimmbare Fabry-Perot-Interferometer angelegten bzw. daran wirkenden elektrischen Spannung berücksichtigt werden kann. Dabei kann eine Korrektur mit einem zu berücksichtigenden Korrekturfaktor erfolgen.

Dies kann bei einer Wellenlänge oder mehreren Wellenlängen erreicht werden, die beim Durchstimmen des Fabry-Perot-Interferometers ohnehin angefahren werden. Es kann daher eine Wellenlängen-Referenzierung des Fabry-Perot-Interferometers bei laufender Messung (ohne) simultan (Pause) durchgeführt werden.

Dabei ist es unerheblich, welche Wellenlänge als Durchlasswellenlänge des Fabry-Perot-Interferometers in diesem Moment ausgewählt worden ist. Es ist lediglich erforderlich die jeweiligen Positionen, Abstände und Anzahl von Minima und/oder Maxima zu kennen, die einer Vorgabe für diese Wellenlänge entsprechen.

Nachfolgend soll die Erfindung beispielhaft näher erläutert werden.

Dabei zeigen:

Figur 1 in schematischer Form den Aufbau einer erfindungsgemäßen Anordnung;

Figur 2 einen Schnitt durch ein an einer erfindungsgemäßen Anordnung einsetzbares elektromagnetische Strahlung detektierendes Element

Figur 3 die spektrale Absorption eines erfindungsgemäßen detektierenden Elements mit einer physikalischen Schichtdicke von etwa 30 μm

Figur 4 das elektrische Signal einer erfindungsgemäßen Anordnung mit einem detektierenden Element, das eine physikalischen Schichtdicke von etwa 20 μm aufweist und einem Fabry-Perot-Interferometer mit einer spektralen Bandbreite von 80 nm bis 4000 nm.

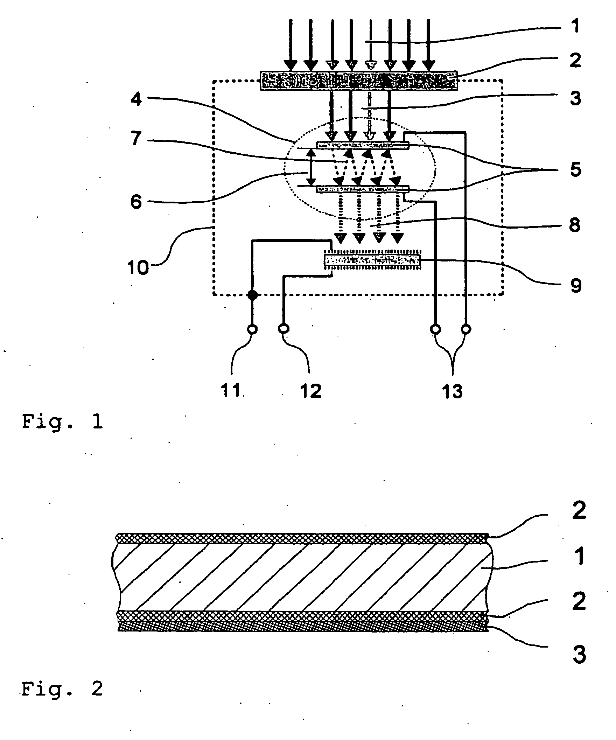

In Figur 1 ist in schematischer Form ein Aufbau eines Beispiels einer erfindungsgemäßen Anordnung gezeigt. Dabei trifft elektromagnetische Strahlung, wie mit den Pfeilen 14 angedeutet auf ein Filterelement 15 auf, das als Bandfilter ausgebildet sein kann und für einen Spektralbereich transparent ist. Der transmittierte Anteil der Strahlung 16 kann mit einem steuer- und durchstimmbaren Fabry-Perot-Interferometer auf eine Durchlasswellenlänge eingestellt werden. Hierzu wird der Abstand 6 zweier reflektierender Elemente 5 mit bestimmten elektrischen Spannungen gezielt eingestellt, was mit den Anschlüssen zu einer elektrischen Spannungsquelle 13 angedeutet ist. Dann trifft monochromatische elektromagnetische Strahlung 8 auf ein detektierendes Element 9 auf, dessen prinzipieller Aufbau mit Figur 2 verdeutlicht werden kann.

Ein detektierendes Element 9 kann mit einer sensitiven Schicht 1 aus Lithium-Tantalat, als ein pyro elektrisches Material gebildet sein. Diese sensitive Schicht 1 ist an beiden gegenüberliegenden Seiten von zwei Elektroden/Reflektor-Schichten 2 eingeschlossen, die aus einer Nickel-Chrom-Legierung gebildet sind. Die beiden Elektroden/Reflektor-Schichten 2 weisen eine gleiche und dabei über die Fläche auch konstante Schichtdicke von 6 nm auf. Die Schichtdicke der sensitiven Schicht 1 beträgt bei diesem Beispiel 28 μm.

Bei dem in Figur 2 gezeigten Beispiel ist zusätzlich eine Verstärkungsschicht 3 vorhanden, die mit Gold gebildet sein kann. Auf der Verstärkungsschicht 3 ist die in Strahlungsrichtung der elektromagnetischen Strahlung nach der sensitiven Schicht 1 angeordnete Elektroden/Reflektor-Schicht 2 ausgebildet.

Über die Anschlüsse 11 und 12 können Messsignale von den Elektroden/Reflektor-Schichten 2 sowie ggf. falls vorhanden auch von der Verstärkungsschicht 3 zu einer nicht dargestellten elektronischen Auswerte- und Steuereinheit übermittelt werden, an die auch die Steuerung für die Einstellung des Abstands 6 der reflektierenden Elemente 5 des Fabry-Perot-Interferometers angeschlossen sein kann.

Für eine Wellenlängen-Referenzierung kann dann für eine vorgegebene Wellenlänge die Anzahl der durch Interferenzen der elektromagnetischen Strahlung zwischen den beiden Elektroden/Reflektor-Schichten 2 ausgebildeten Maxima, Minima und/oder der Abstand zwischen detektierter Maxima und/oder Minima bestimmt werden. Daraus wiederum kann ein Korrekturfaktor für die an das Fabry-Perot-Interferometer angelegte elektrische Spannung bestimmt werden, um eine Abweichung von Vorgaben für einen Abstand 6 der reflektierenden Elemente 5 zu kompensieren und das Fabry-Perot-Interferometer auf die jeweils gewünschte Durchlasswellenlänge einstellen zu können.

Die Anordnung kann in einem geschlossenen Gehäuse 10 aufgenommen sein, in das das Filterelement 12 eingesetzt ist, durch das die elektromagnetische Strahlung auf Fabry-Perot-Interferometer und detektierendes Element 9 gerichtet werden kann.

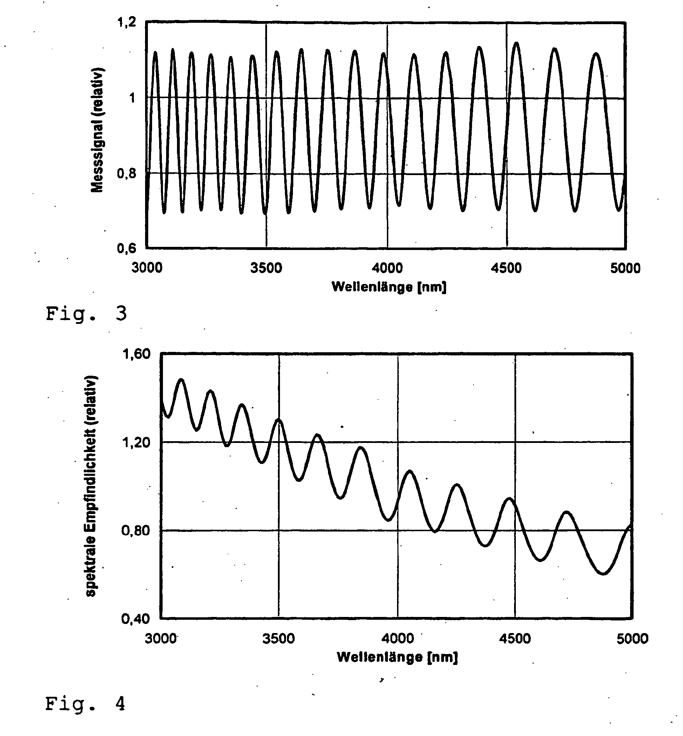

In Figur 3 ist das relative Signal einer erfindungsgemäßen Anordnung mit einem detektierenden Element im Spektralbereich von 3000-5000nm dargestellt. Die Messung des Signals erfolgte spektral schmalbandig mit einem Fourier-Transform-Infrarot-Spektrometer bei einer spektralen Auflösung von 4 Wellenzahlen. Die sensitive Schicht 1 des detektierenden Elements 9 besteht aus Lithium-Tantalat und ist 28 $\mu$m dick. Die Elektroden/Reflektor-Schichten 2 sind aus NiCr und 6 nm dick. Die Verstärkungsschicht 3 ist aus Gold und ebenfalls 6 nm dick. Aufgrund der sehr niedrigen Absorption des Lithium-Tantalats in diesem Spektralbereich bilden sich 17 Minima und 17 Maxima im Spektralbereich 3000-5000 nm aus. Die Maxima weisen ein relatives Signal von etwa 1,1 und die Minima ein relatives Signal von etwa 0,7 auf. Die relative Amplitude beträgt also 20%. Der Abstand zwischen benachbarten Maxima/Minima wird mit zunehmender Wellenlänge größer. Der Abstand, der auch ein Maß für die spektrale Bandbreite ist, beträgt bei einer Wellenlänge von 3000 nm etwa 76 nm und vergrößert sich auf 178 nm bei 5000 nm.

Figur 4 zeigt das relative Signal einer erfindungsgemäßen Anordnung mit einem detektierenden Element 9 im Spektralbereich von 3000-5000nm, wenn es durch ein durchstimmbares Fabry-Perot-Interferometer mit einer spektralen Bandbreite von 80 nm beleuchtet wird. Im Gegensatz zu Figur 3 ist hier die sensitive Schicht 1 18 $\mu$m dick. Die im Vergleich zu Figur 3 dünnere sensitive Schicht 1 hat zur Folge, dass weniger Minima/Maxima im Spektralbereich von 3000nm -5000 nm mit deutlich größerer spektraler Bandbreite von 120 nm bei 3000 nm und 270 nm bei 5000 nm entstehen. Dadurch wird gewährleistet, dass die einzelnen Minima und Maxima bei der Abtastung mit dem 80 nm breiten gefilterten spektralen Strahlung des Fabry-Perot-Interferometers noch aufgelöst werden können.

**Patentansprüche**

1. Anordnung zur Wellenlängen-Referenzierung von durchstimmbaren Fabry-Perot-Interferometern, bei der von einer Strahlungsquelle emittierte elektromagnetische Strahlung nach Durchdringung eines Fluids über ein durchstimmbares Fabry-Perot-Interferometer gerichtet und durch das Fabry-Perot-Interferometer transmittierte elektromagnetische Strahlung auf ein elektromagnetische Strahlung detektierendes Element (9) gerichtet ist, mit dem elektrische Messsignale in Abhängigkeit der Intensität der auftreffenden elektromagnetischen Strahlung generiert werden, wobei die Anordnung ein Fabry-Perot- Interferometer, ein detektierendes Element und eine elektronische Auswerte- und Steuereinheit umfasst, **dadurch gekennzeichnet, dass** das detektierende Element (9) aus mindestens drei Schichten (1, 2) gebildet ist und dabei zwei Elektroden/Reflektor-Schichten (2) eine sensitive, mit einem pyroelektrischen Stoff gebildete Schicht (1) mit einer über die gesamte Fläche konstanten optischen Schichtdicke n*d, die aus einem für elektromagnetische Strahlung sensitiven Stoff gebildet ist, so dass elektromagnetische Strahlung zwischen den Elektroden/Reflektorschichten (2) mehrfach durch die sensitive Schicht (1) hin und her reflektiert wird, so dass Interferenzen hervor gerufen werden;
und
die beiden im Strahlengang der elektromagnetischen Strahlung vor und hinter der sensitiven Schicht (1) angeordneten Elektroden/Reflektor-Schichten (2) elektrisch leitend und für die elektromagnetische Strahlung teilweise reflektierend und teilweise transparent sind und
die im Strahlengang vor der sensitiven Schicht (1) angeordnete Elektroden/Reflektor-Schicht (2) und die danach angeordnete (n) Schicht(en) (2, 3) an eine elektronische Auswerte- und Steuereinheit, zur Bestimmung eines Korrekturfaktors für eine kontrollierte Einstellung des Abstandes der reflektierenden Elemente (5), aus der Anzahl detektierter Maxima, Minima und/oder des Abstandes zwischen detektierter Maxima und/oder Minima der elektromagnetischen Strahlung, angeschlossen sind.

2. Anordnung nach Anspruch 1, **dadurch gekennzeichnet, dass** das pyroelektrische Material im spektralen Durchstimmbereich des Fabry-Perot-Interferometers einen geringen Absorptionskoeffizienten k von kleiner 0,01 aufweist.

3. Anordnung nach einem der vorhergehenden Ansprüche, **dadurch gekennzeichnet, dass** die sensitive Schicht (1) eine optische Schichtdicke n*d im Bereich 20 bis 90 $\mu$m aufweist.

4. Anordnung nach einem der vorhergehenden Ansprüche, **dadurch gekennzeichnet, dass** die im Strahlengang der elektromagnetischen Strahlung hinter der sensitiven Schicht (1) angeordnete Elektroden/Reflektor-Schicht (2) auf einer Verstärkungsschicht (3) ausgebildet ist.

5. Anordnung nach einem der vorhergehenden Ansprüche, **dadurch gekennzeichnet, dass** die im Strahlengang vor der sensitiven Schicht (1) angeordnete Elektroden/Reflektor-Schicht (2) und die danach angeordnete(n) Schicht(en) (2, 3) an eine elektronische Auswerte- und Steuereinheit zur Übertragung der Messsignale angeschlossen sind.

6. Anordnung nach einem der vorhergehenden Ansprüche, **dadurch gekennzeichnet, dass** die beiden Elektroden/Reflektor-Schichten (2), zwischen denen die sensitive Schicht (1) angeordnet ist, die gleiche Schichtdicke aufweisen.

7. Anordnung nach Anspruch 6, **dadurch gekennzeichnet, dass** die Elektroden/Reflektor-Schichten (2) eine Schichtdicke im Bereich 2 bis 20 nm aufweisen.

8. Anordnung nach Anspruch 6 oder 7, **dadurch gekennzeichnet, dass** die Elektroden/Reflektor-Schichten (2) aus dem gleichen Stoff gebildet sind.

9. Anordnung nach einem der Ansprüche 6 bis 8, **dadurch gekennzeichnet, dass** die Elektroden/Reflektor-Schichten (2) aus einer NickelChrom-Legierung oder Chrom gebildet sind.

10. Anordnung nach einem der vorhergehenden Ansprüche, **dadurch gekennzeichnet, dass** die sensitive Schicht (1) aus Lithium-Tantalat gebildet ist.

11. Anordnung nach einem der vorhergehenden Ansprüche, **dadurch gekennzeichnet, dass** im Strahlengang vor dem Fabry-Perot-Interferometer ein optisches Filterelement (12) angeordnet ist.

12. Verfahren zur Wellenlängen-Referenzierung der Anordnung nach einem der vorhergehenden Ansprüche, bei dem elektromagnetische Strahlung (11) durch ein durchstimmbares Fabry-Perot-Interferometer, das mit zwei parallel zueinander ausgerichteten reflektierenden Elementen (5), die an eine steuerbare elektrische Spannungsquelle (13) angeschlossen sind, auf ein elektromagnetische Strahlung detektierendes Element (9) gerichtet ist, und der Abstand (6) zwischen den reflektierenden Elementen (5) durch kontrolliertes Anlegen der elektrischen Spannung eingestellt wird; um eine bestimmte Durchlasswellenlänge des Fabry-Perot-Interferometers einzustellen; und zur Wellenlängen-Referenzierung mit dem elektromagnetische Strahlung detektierenden Element (9) die Anzahl detektierter Maxima, Minima und/oder der Abstand zwischen detektierten Maxima und/oder Minima der elektromagnetischen Strahlung bestimmt und daraus ein Korrekturfaktor für die Steuerung der an die reflektierenden Elemente (5) angelegten elektrischen Spannung bestimmt wird.

13. Verfahren nach Anspruch 12, **dadurch gekennzeichnet, dass** die Wellenlängen-Referenzierung bei einer elektrischen Spannung, die einem Abstand (6) der reflektierenden Elemente (5) entspricht, bei der das Fabry-Perot-Interferometer für eine Absorptionsbande eines jeweiligen zu detektierenden Stoffs transparent ist, durchgeführt wird.

## Claims

1. A device for the wavelength referencing of tunable Fabry-Pérot interferometers, in which, after the penetration of a fluid, electromagnetic radiation emitted by a source of radiation is directed by way of a tunable Fabry-Pérot interferometer and electromagnetic radiation transmitted by the Fabry-Pérot interferometer is directed onto an element (9) which detects electromagnetic radiation and by which electrical measurement signals are generated in a manner dependent upon the intensity of the impinging electromagnetic radiation, wherein the device comprises a Fabry-Pérot interferometer, a detecting element and an electronic evaluation and control unit, **characterized in that** the detecting element (9) is formed from at least three layers (1, 2), in this case two electrode / reflector layers (2), a sensitive layer (1) formed with a pyroelectrical substance with an optical layer thickness **n*d** which is constant over the entire area and which is formed from a substance sensitive to electromagnetic radiation, so that electromagnetic radiation is reflected backwards and forwards a multiplicity of times between the electrode / reflector layers (2) by the sensitive layer (1), so that interferences are caused; and
the two electrode / reflector layers (2) arranged upstream and downstream of the sensitive layer (1) in the optical path of the electromagnetic radiation are electrically conductive and are partially reflecting and partially transparent for the electromagnetic radiation, and
the electrode / reflector layer (2) arranged upstream of the sensitive layer (1) in the optical path and the layer or layers (2, 3) arranged downstream thereof are connected to an electronic evaluation and control unit, in order to determine a correction factor for a controlled setting of the distance of the reflecting elements (5), from the number of detected maxima, minima and/or of the distance between detected maxima and/or minima of the electromagnetic radiation.

2. A device according to Claim 1, **characterized in that** the pyroelectrical material has a low absorption coefficient **k** of less than 0,01 in the spectral tuning range of the Fabry-Pérot interferometer.

3. A device according to one of the preceding Claims, **characterized in that** the sensitive layer (1) has an optical layer thickness **n*d** in the range of from 20

to 90 μm.

**4.** A device according to any one of the preceding Claims, **characterized in that** the electrode / reflector layer (2) arranged downstream of the sensitive layer (1) in the optical path of the electromagnetic radiation is formed on a reinforcement layer (3).

**5.** A device according to any one of the preceding Claims, **characterized in that** the electrode / reflector layer (2) arranged upstream of the sensitive layer (1) in the optical path and the layer or layers (2, 3) arranged downstream thereof are connected to an electronic evaluation and control unit for the transmission of the measurement signals.

**6.** A device according to any one of the preceding Claims, **characterized in that** the two electrode / reflector layers (2), between which the sensitive layer (1) is arranged, have the same layer thickness.

**7.** A device according to Claim 6, **characterized in that** the electrode / reflector layers (2) have a layer thickness in the range of from 2 to 20 nm.

**8.** A device according to Claim 6 or 7, **characterized in that** the electrode / reflector layers (2) are formed from the same material.

**9.** A device according to any one of Claims 6 to 8, **characterized in that** the electrode /reflector layers (2) are formed from a nickel-chromium alloy or from chromium.

**10.** A device according to any one of the preceding Claims, **characterized in that** the sensitive layer (1) is formed from lithium tantalate.

**11.** A device according to any one of the preceding Claims, **characterized in that** an optical filter element (12) is arranged upstream of the Fabry-Pérot interferometer in the optical path.

**12.** A method of wavelength referencing of the device according to any one of the preceding Claims, in which electromagnetic radiation (11) is set by a tunable Fabry-Pérot interferometer, which is directed onto an element (9) detecting electromagnetic radiation by two reflecting elements (5) which are orientated parallel to each other and which are connected to a controllable source of radiation (13), and the distance (6) between the reflecting elements (5) is set by controlled application of the electrical voltage, in order to set a pre-determined cut-off wavelength of the Fabry-Pérot interferometer; and for the wavelength referencing the number of detected maxima, minima and/or the distance between detected maxima and/or minima of the electromagnetic radiation is determined by the element (9) which detects electromagnetic radiation, and a correction factor for controlling the electrical voltage applied to the reflecting elements (5) is determined therefrom.

**13.** A method according to Claim 12, **characterized in that** the wavelength referencing is carried out at an electrical voltage which corresponds to a distance (6) between the reflecting elements (5) and in which the Fabry-Pérot interferometer is transparent for an absorption band of a respective substance to be detected.

**Revendications**

**1.** Dispositif de référencement par longueur d'onde des interféromètres de Fabry-Pérot ajustables, dans lequel un rayonnement électromagnétique, émis par une source de rayonnement, est diri gé, après avoir traversé un fluide, par l'intermédiaire d'un interféromètre de Fabry-Pérot ajustable et un rayonnement électromagnétique, transmis par l'interféromètre de Fabry-Pérot, est dirigé sur un élément (9) détectant un rayonnement électromagnétique, avec lequel sont générés des signaux de mesure électriques en fonction de l'intensité du rayonnement électromagnétique produit, ledit dispositif comportant un interféromètre de Pabry-Pérot, un élément détecteur et une unité électronique d'analyse et de commande, **caractérisé en ce que** l'élément détecteur (9) est formé par au moins trois couches (1, 2), à savoir deux couches électrodes/réfléchissantes (2), une couche sensitive (1), formée par un matériau pyroélectrique, ayant une épaisseur de couche n*d optique constante sur toute la surface, qui est formée par un matériau sensible à un rayonnement électromagnétique, de telle sorte que le rayonnement électromagnétique est réfléchi entre les couches électrodes/réfléchissantes (2) en va-et-vient à plusieurs reprises par la couche sensitive (1), de manière à générer des interférences ;
et
les deux couches électrodes/réfléchissantes (2), agencées dans la trajectoire du rayonnement électromagnétique en amont et en aval de la couche sensitive (1), sont électroconductrices et sont partiellement réfléchissantes et partiellement transparentes pour le rayonnement électromagnétique, et la couche électrode/réfléchissante (2), agencée en amont de la couche sensitive (1) dans la trajectoire du rayonnement, et les couches (2, 3), agencées en aval, sont raccordées à une unité électronique d'analyse et de commande, en vue de déterminer un facteur de correction pour un réglage contrôlé de la distance entre les éléments réfléchissants (5), à partir du nombre de maxima, minima détectés et/ou de la distance entre les maxima et/ou les minima détectés du rayonnement électromagnétique,

2. Dispositif selon la revendication 1, **caractérisé en ce que** le matériau pyroélectrique comporte, dans le domaine d'ajustement spectral de l'interféromètre de Fabry-pérot, un faible coefficient d'absorption K inférieur à 0,01.

3. Dispositif selon l'une quelconque des revendications précédentes, **caractérisé en ce que** la couche sensitive (1) possède une épaisseur de couche optique n*d dans une plage de 20 à 90 $\mu$m.

4. Dispositif selon l'une quelconque des revendications précédentes, **caractérisé en ce que** la couche électrode/réfléchissante (2), agencée en aval de la couche sensitive (1) dans la trajectoire du rayonnement électromagnétique, est réalisée sur une couche de renfort (3).

5. Dispositif selon l'une quelconque des revendications précédentes, **caractérisé en ce que** la couche élecirode/réfléchissante (2), agencée en amont de la couche sensitive (1) dans la trajectoire du rayonnement, et la/les couche(s) (2, 3), agencée(s) en aval, sont raccordées à une unité électronique d'analyse et de commande en vue de la transmission des signaux de mesure.

6. Dispositif selon l'une quelconque des revendications précédentes, **caractérisé en ce que** les deux couches électrodes/réfléchissantes (2), entre lesquelles est agencée la couche sensitive (1), ont la même épaisseur de couche.

7. Dispositif selon la revendication 6, **caractérisé en ce que** les couches électrodes/réfléchissantes (2) ont une épaisseur de couche dans une plage de 2 à 20 nm.

8. Dispositif selon la revendication 6 ou 7, **caractérisé en ce que** les couches électrodes/réfléchissantes (2) sont réalisées dans le même matériau.

9. Dispositif selon l'une quelconque des revendications 6 à 8, **caractérisé en ce que** les couches électrodes/réfléchissantes (2) sont réalisées dans un alliage de nickel-chrome ou en chrome.

10. Dispositif selon l'une quelconque des revendications précédentes, **caractérisé en ce que** la couche sensitive (1) est réalisée en lithium-tantalate.

11. Dispositif selon l'une quelconque des revendications précédentes, **caractérisé en ce que** dans la trajectoire du rayonnement, en amont de l'interféromètre de Fabry-Pérot, est disposé un élément de filtre (12) optique.

12. Procédé de référencement par longueur d'onde du dispositif selon l'une quelconque des revendications précédentes, dans lequel
un rayonnement électromagnétique (11) est dirigé par un interféromètre de Fabry-Pérot ajustable, avec deux éléments réfléchissants (5), qui sont orientés parallèlement l'un à l'autre et qui sont raccordés à une source de tension électrique (13) apte à être commandée, sur un élément (9) détectant un rayonnement électromagnétique, et la distance (6) entre les éléments réfléchissants (5) est réglée par une application contrôlée de la tension électrique, pour régler une longueur d'ondes de passage déterminée de l'interféromètre de Fabry-Pérot ; et pour le référencement par longueur d'onde avec l'élément (9) détectant le rayonnement, électromagnétique est déterminé le nombre de maxima, minima détectés et/ou la distance entre les maxima et/ou les minima détectés du rayonnement électromagnétique et à partir de là est calculé un facteur de correction pour la commande de la tension électrique appliquée aux éléments réfléchissants (5).

13. Procédé selon la revendication 12, **caractérisé en ce que** le référencement par longueur d'onde est effectué en présence d'une tension électrique qui correspond à une distance (6) entre les éléments réfléchissants (5), en présence de laquelle l'interféromètre de Fabry-Pérot est transparent pour une bande d'absorption d'un matériau à détecter.

1

2

3

4

7

5

6

8

10

9

11     12          13

Fig. 1

2

1

2

3

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5646729 A
- US 2003116711 A

- DE 69628974 T2